# EUROPEAN PATENT APPLICATION

(11) **EP 4 671 746 A1**
(43) Date of publication of application: **31.12.2025**
(21) Application number: 24829717.8
(22) Date of filing: 08.01.2024
(51) Int. Cl.: G01N 23/04, G01N 23/02

(54) **TESTING APPARATUS AND BATTERY CELL TESTING DEVICE**

(30) Priority: 30.06.2023 CN 202321704191 U
(71) Applicant: Contemporary Amperex Technology Co., Limited, Ningde, Fujian 352100 (CN)
(72) Inventor: WU, Kai, Ningde, Fujian 352100 (CN); HUANG, Dengdeng, Ningde, Fujian 352100 (CN); YANG, Mukai, Ningde, Fujian 352100 (CN); HUANG, Qinkun, Ningde, Fujian 352100 (CN); PAN, Wensheng, Ningde, Fujian 352100 (CN); FAN, Xiang, Ningde, Fujian 352100 (CN)
(74) Representative: Lorenz Seidler Gossel Part. mbB
(86) International application number: PCT/CN2024/071155
(87) International publication number: WO 2025/001054

(57) **Abstract**

Provided in the present application are a testing apparatus and a battery cell testing device. The testing apparatus comprises: a ray source and a ray detector, which are oppositely arranged; and a carrying mechanism, which is located between the ray source and the ray detector, wherein the carrying mechanism comprises a carrying body and a first shielding plate, the first shielding plate is configured to block at least some rays projected onto the first shielding plate from penetrating through, the carrying body is configured for the placement of an object to be tested, edges of a projection area of rays emitted by the ray source on the plane where the first shielding plate is located are located inside edges of the first shielding plate, and the first shielding plate is configured to match said object so that the rays emitted by the ray source are projected to the ray detector through at least one of the first shielding plate and said object.

## Description

### CROSS-REFERENCE

The present application refers to Chinese Patent Application No. 202321704191.0 entitled "TESTING APPARATUS AND BATTERY CELL TESTING DEVICE" filed on June 30, 2023, which is incorporated herein by reference in its entirety.

### TECHNICAL FIELD

The present application relates to the technical field of batteries, and in particular, to a detection apparatus and a battery cell detection device.

### BACKGROUND

Energy conservation and emission reduction are the key to sustainable development of the automobile industry. Electric vehicles have become an important part of the sustainable development of the automobile industry due to their energy-saving and environmental protection advantages. For electric vehicles, the battery technology is an important factor in their development.

Battery safety has always been a subject of great concern. In addition to safety-oriented design, safety inspection after battery assembly is also indispensable. Before leaving the factory, the battery may be subjected to inspections, including detection of coverage deviation between the positive electrode plate and the negative electrode plate, alignment detection of the positive electrode plate and the negative electrode plate, distance detection between adjacent electrode plates, detection of the total number of electrode plates in the battery cell, and other required inspection items. In the related art, there is still room for improvement in battery cell detection apparatuses.

### SUMMARY

The present application aims to solve at least one of the technical problems existing in the background. Therefore, an objective of the present application is to provide a detection apparatus and a battery cell detection device, to reduce the amount of radiation projected onto the radiation detector, thereby prolonging the service life of the radiation detector.

Embodiments of a first aspect of the present application provide a detection apparatus. The detection apparatus includes a radiation source and a radiation detector disposed opposite to each other, and a supporting mechanism located between the radiation source and the radiation detector. The supporting mechanism includes a supporting body and a first shielding plate, the first shielding plate is configured to block at least a portion of radiation projected onto the first shielding plate from penetrating through, and the supporting body is configured to carry a to-be-detected object. An edge of a projection region of the radiation emitted from the radiation source on a plane where the first shielding plate is located is positioned on an inner side of an edge of the first shielding plate. The first shielding plate is configured to cooperate with the to-be-detected object, such that the radiation emitted from the radiation source is projected onto the radiation detector through at least one of the first shielding plate and the to-be-detected object.

In the technical solutions of the embodiments of the present application, the first shielding plate in the detection apparatus blocks at least a portion of the radiation projected onto the first shielding plate from penetrating through, such that the amount of the radiation emitted from the radiation source that is projected onto the radiation detector can be reduced. The edge of the projection region of the radiation emitted from the radiation source on the plane where the first shielding plate is located is positioned on the inner side of the edge of the first shielding plate, and the first shielding plate cooperates with the to-be-detected object, such that the radiation emitted from the radiation source is projected onto the radiation detector through at least one of the first shielding plate and the to-be-detected object, thereby reducing formation of direct exposure areas caused by direct projection of the radiation onto the radiation detector, and consequently increasing the service life of the radiation detector.

In some embodiments, a window is formed on the first shielding plate, and the window corresponds to a position of the to-be-detected object on the supporting body. By forming the window on the first shielding plate and aligning the window with the position of the to-be-detected object on the supporting body, the first shielding plate cooperates with the to-be-detected object such that the radiation emitted from the radiation source is projected onto the radiation detector through at least one of the first shielding plate and the to-be-detected object. Additionally, the formation of the window on the first shielding plate does not affect the amount of the radiation penetrating through the to-be-detected object, and therefore does not impact the detection of the to-be-detected object.

In some embodiments, a surface, facing the radiation source, of the supporting body includes an accommodating groove, the accommodating groove being configured to accommodate the to-be-detected object. By arranging the accommodating groove on the surface, facing the radiation source, of the supporting body to accommodate the to-be-detected object, the to-be-detected object is securely placed on the supporting body. In another aspect, the blocking effect of the supporting body on the radiation can be reduced, and the imaging quality of the to-be-detected object on the radiation detector can be improved.

In some embodiments, when the window is formed on the first shielding plate, the accommodating groove corresponds to a position of the window, and the accommodating groove and the window have identical shape and size. By aligning the accommodating groove with the position of the window, the amount of the radiation penetrating through the to-be-detected object is not affected, thereby avoiding impact on the detection of the to-be-detected object. Meanwhile, the accommodating groove and the window are configured with identical shape and size, thereby reducing formation of direct exposure areas caused by direct projection of the radiation onto the radiation detector, and consequently increasing the service life of the radiation detector.

In some embodiments, the first shielding plate is closely attached to a surface of the supporting body. The first shielding plate is closely attached to the surface of the supporting body, such that the amount of the radiation projected onto the radiation detector through the gap between the first shielding plate and the supporting body can be reduced, thereby further prolonging the service life of the radiation detector.

In some embodiments, the first shielding plate is disposed on a surface, facing the radiation source, of the supporting body. The first shielding plate is disposed on the surface, facing the radiation source, of the supporting body, that is, the supporting body supports the first shielding plate. The structural design is relatively simple and is easy to manufacture. When the to-be-detected object is placed on the surface, facing the radiation source, of the supporting body, the amount of the radiation projected onto the radiation detector through the gap between the first shielding plate and the supporting body can be further reduced, thereby further prolonging the service life of the radiation detector.

In some embodiments, the supporting mechanism includes a plurality of supporting bodies, the supporting mechanism further includes a second shielding plate disposed between two adjacent supporting bodies, and an orthographic projection of the second shielding plate on a plane where the surface, facing the radiation source, of the supporting body is located at least covers a gap between two adjacent supporting bodies. The second shielding plate is disposed between two adjacent supporting bodies, and the orthographic projection of the second shielding plate on the plane where the surface, facing the radiation source, of the supporting body is located at least covers the gap between two adjacent supporting bodies, such that the radiation projected onto the second shielding plate can be blocked to some extent from being projected onto the radiation detector through the gap between two adjacent supporting bodies, thereby further reducing the amount of the radiation projected onto the surface of the radiation detector, and prolonging the service life of the radiation detector.

In some embodiments, the second shielding plate includes a first portion and a second portion, the first portion is disposed on the surface, facing the radiation source, of the supporting body, the second portion is connected to the first portion, and an orthographic projection of the second portion on a plane where the surface, facing the radiation source, of the supporting body is located at least covers a gap between two adjacent supporting bodies. Therefore, the second shielding plate can block the radiation projected onto the second shielding plate from being projected onto the radiation detector through the gap between two adjacent supporting bodies. In addition, the second shielding plate has a simple structure and is easy to secure.

In some embodiments, a distance between a surface, facing the detector, of the second portion and the surface, facing the radiation source, of the supporting body is greater than or equal to a maximum thickness of the first shielding plate. By setting the distance between the surface, facing the detector, of the second portion and the surface, facing the radiation source, of the supporting body to be greater than or equal to the maximum thickness of the first shielding plate, the second portion of the second shielding plate may not be blocked by the first shielding plate, ensuring that the orthographic projection of the second shielding plate on the plane where the surface, facing the radiation source, of the supporting body is located completely covers the gap between two adjacent supporting bodies.

In some embodiments, the detection apparatus further includes a control element and a position detection assembly, the position detection assembly being configured to detect position information of the to-be-detected object, and the control element being configured to activate or deactivate the radiation source based on the position information of the to-be-detected object. The control element activates or deactivates the radiation source based on the position information of the to-be-detected object, such that the activation and deactivation time of the radiation source can be controlled, and the activation time of the radiation source can be reduced, thereby decreasing the duration of radiation exposure of the radiation detector, and further prolonging the service life of the radiation detector.

In some embodiments, the detection apparatus further includes a driving mechanism, where the driving mechanism is configured to drive the supporting mechanism to move, the position detection assembly includes a magnetic grating scale and a magnetic grating scale read head, the magnetic grating scale is disposed on a side surface of the supporting body adjacent to the surface, facing the radiation source, of the supporting body along a movement direction of the supporting mechanism, and the magnetic grating scale read head obtains the position information of the to-be-detected object based on magnetic pole variations of the magnetic grating scale. Since the magnetic grating scale is disposed on a side surface of the supporting body adjacent to the surface, facing the radiation source, of the supporting body along a movement direction of the supporting mechanism, and the magnetic grating scale read head obtains the position information of the to-be-detected object based on magnetic pole variations of the magnetic grating scale, the position detection assembly with such structural configuration offers the advantages of structural simplicity and high detection efficiency.

The embodiments of a second aspect of the present application provide a battery cell detection device. The battery cell detection device includes the detection apparatus in the aforementioned embodiments, and the to-be-detected object is a battery cell.

The above description is only an overview of the technical solutions of the present application. To more clearly understand the technical means of the present application to enable implementation in accordance with the content of the specification and to make the above and other purposes, features, and advantages of the present application more obvious and easier to understand, the detailed description of the present application is provided below.

### BRIEF DESCRIPTION OF THE DRAWINGS

In the drawings, unless otherwise specified, the same reference numerals across multiple drawings indicate the same or similar components or elements. The drawings are not necessarily drawn to scale. It should be understood that the drawings depict only some implementations of the present application and therefore should not be considered as limiting the scope of the present application. To more clearly illustrate the technical solutions in the embodiments of the present application, the drawings required for illustrating the embodiments of the present application are briefly described below. Apparently, the drawings in the following description illustrate merely some embodiments of the present application, and those of ordinary skills in the art may still derive other drawings from these drawings without creative efforts.
FIG. 1 is a schematic structural diagram of a detection apparatus according to some embodiments of the present application;
FIG. 2 is a schematic structural diagram of a supporting mechanism according to some embodiments of the present application;
FIG. 3 is a left view of a supporting mechanism according to some embodiments of the present application;
FIG. 4 is a schematic exploded view of a supporting mechanism according to some embodiments of the present application;
FIG. 5 is a left view of FIG. 4;
FIG. 6 is a schematic structural diagram of another detection apparatus according to some embodiments of the present application; and
FIG. 7 is a schematic structural diagram of a detection apparatus according to some other embodiments of the present application.

Description of the reference numerals:
100: detection apparatus; 110: radiation source; 120: radiation detector; 130: supporting mechanism; 140: to-be-detected object; 150: control element; 160: position detection assembly; 170: radiation; 131: supporting body; 132: first shielding plate; 1321: window; 133: second shielding plate; 1331: first portion; 1332: second portion; 161: magnetic grating scale; 162: magnetic grating scale read head.

### DETAILED DESCRIPTION

Embodiments of the technical solutions of the present application will be described in detail below with reference to the drawings. The following embodiments are only used to more clearly illustrate the technical solutions of the present application, and therefore, are only exemplary and do not limit the claimed scope of the present application.

Unless otherwise defined, all technical and scientific terms used herein have the same meaning as commonly understood by those skilled in the technical field to which the present application belongs. The terms used herein are only used to illustrate the specific embodiments, rather than limit the present application. The terms "include", "comprise", and "provided with", and any variations thereof in the specification and claims of the present application and the above drawing description encompass non-exclusive inclusions.

In the description of the embodiments of the present application, the technical terms "first", "second", and the like are only used to distinguish different objects and should not be interpreted as indicating or implying the relative importance or implicitly indicating the number, specific order, or primary and secondary relationship of the noted technical features. In the description of the embodiments of the present application, unless otherwise specifically defined, "plurality of" means two or more.

Reference in the present application to "embodiment" means that a particular feature, structure, or characteristic described in combination with the embodiment can be included in at least one embodiment of the present application. The references of the word in the context of the specification do not necessarily refer to the same embodiment, nor to separate or alternative embodiments exclusive of other embodiments. It will be explicitly and implicitly appreciated by those skilled in the art that the embodiments described herein can be combined with other embodiments.

In the description of the embodiments of the present application, the term "and/or" is merely a way to describe the associative relationship between associated objects, indicating that there are three possible relationships. For example, "A and/or B" may denote: the presence of A alone, the simultaneous presence of A and B, and the presence of B alone. In addition, the character "/" herein generally indicates an "or" relationship between the associated objects before and after the "/".

In the description of the embodiments of the present application, the term "plurality of" refers to two or more (including two). Similarly, "plurality of groups" refers to two or more (including two) groups, and "plurality of pieces" refers to two or more (including two) pieces.

In the description of the embodiments of the present application, the technical terms "center", "longitudinal", "transverse", "length", "width", "thickness", "upper", "lower", "front", "rear", "left", "right", "vertical", "horizontal", "top", "bottom", "inner", "outer", "clockwise" "counterclockwise", "axial", "radial", "circumferential" and the like indicate orientations or positional relationships based on those shown in the drawings. They are merely for the convenience of describing the embodiments of the present application and simplifying the description, rather than indicating or implying that the apparatus or element referred to must have a specific orientation or be constructed and operated in the specific orientation, and thus should not be construed as limitations on the embodiments of the present application.

In the description of the embodiments of the present application, unless otherwise clearly specified and defined, the technical terms "mount", "interconnect", "connect", "fix", and the like should be interpreted in their broad senses. For example, they may be a fixed connection, a detachable connection, or an integral connection; a mechanical connection or an electrical connection; or a direct connection, an indirect connection via an intermediate, a communication between interiors of two elements, or an interaction between two elements. For those of ordinary skills in the art, the specific meanings of the above terms in the embodiments of the present application can be interpreted according to specific conditions.

Currently, conventional non-destructive detection apparatuses typically employ radiation detector imaging systems, namely X-ray imaging detection. During the detection process, a portion of X-rays projected onto an object to be detected is absorbed and scattered by the object to be detected, while another portion penetrates through the object to be detected and propagates along the original direction. Due to variations in density, thickness, and other aspects of different parts of the object to be detected, the absorption of X-rays projected thereon differs, thereby transmitting image information of the object to be detected to the radiation detector in the form of varying X-ray intensities.

X-rays are a type of high-energy radiation. Apparatuses such as X-ray tubes, magnetrons, and klystrons serve as generating apparatuses for X-ray sources, where electrons in an electric current are accelerated to bombard a heavy metal target at high velocity, thereby emitting X-rays. The high-energy particles of X-rays exhibit strong penetration effect on substances and may cause irreparable damage to the radiation detector, significantly reducing the service life of the radiation detector. Therefore, protective measures are necessary for the radiation detector when radiation detector imaging systems are employed.

Accordingly, the present application provides a detection apparatus that reduces the amount of radiation projected onto the radiation detector by utilizing a shielding plate to block at least a portion of the radiation projected onto the shielding plate from penetrating through, thereby prolonging the service life of the radiation detector.

The detection apparatus disclosed in the embodiments of the present application may be applicable to, but is not limited to, battery cell detection, and may be applicable to, but is not limited to, detection processes in the production process of battery cells. The service life of the detection apparatus of the present application can be prolonged, thereby improving the detection efficiency of battery cell detection, and further improving the production efficiency of battery cells.

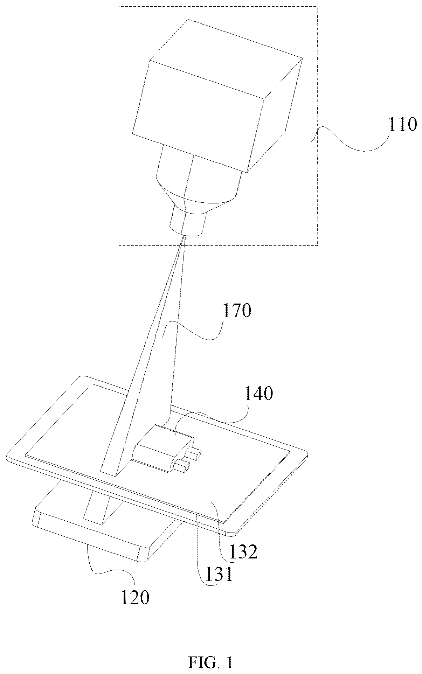

FIG. 1 is a schematic structural diagram of a detection apparatus according to some embodiments of the present application. As shown in FIG. 1, the detection apparatus 100 includes a radiation source 110 and a radiation detector 120 disposed opposite to each other, and a supporting mechanism 130 located between the radiation source 110 and the radiation detector 120. The supporting mechanism 130 includes a supporting body 131 and a first shielding plate 132, the first shielding plate 132 is configured to block at least a portion of radiation 170 projected onto the first shielding plate 132 from penetrating through, and the supporting body 131 is configured to carry a to-be-detected object 140. An edge of a projection region of the radiation 170 emitted from the radiation source 110 on a plane where the first shielding plate 132 is located is positioned on an inner side of an edge of the first shielding plate 132. The first shielding plate 132 is configured to cooperate with the to-be-detected object 140, such that the radiation 170 emitted from the radiation source 110 is projected onto the radiation detector 120 through at least one of the first shielding plate 132 and the to-be-detected object 140.

In some embodiments of the present application, the radiation source 110 refers to an apparatus, such as an X-ray source, capable of emitting the radiation 170. The radiation detector 120 may be a flat panel detector or a time delay integration (TDI) detector, and the flat panel detector is an area array detector capable of directly imaging the incident X-rays. The TDI detector is a linear image sensor. A pixel row of the image sensor is perpendicular to the movement direction of an object to be detected, thereby achieving high-speed and high-resolution image acquisition. The radiation detector 120 can convert the received radiation energy into recordable electrical signals. By measuring the amount of radiation received by the radiation detector 120, electrical signals proportional to the amount of radiation are generated, thereby forming a corresponding image. Illustratively, the radiation detector 120 may include three parts: a radiation conversion module, a photoelectric conversion module, and a signal readout and transmission module. During the detection process of the to-be-detected object 140 by the detection apparatus 100, the to-be-detected object 140 is placed within the radiation area of the radiation source 110, the radiation 170 emitted by the radiation source 110 is emitted from the radiation window, and the emitted radiation 170 penetrates through the to-be-detected object 140 and then is projected onto the radiation detector 120. The radiation detector 120 receives the radiation penetrating through the to-be-detected object 140 and images the to-be-detected object 140.

In some embodiments of the present application, the supporting mechanism 130 includes a supporting body 131 and a first shielding plate 132. The supporting body 131 is configured to carry the to-be-detected object 140. The first shielding plate 132 may be disposed on the surface, facing the radiation source 110, of the supporting body 131, and the first shielding plate 132 may also be disposed on the surface, facing the radiation detector 120, of the supporting body 131.

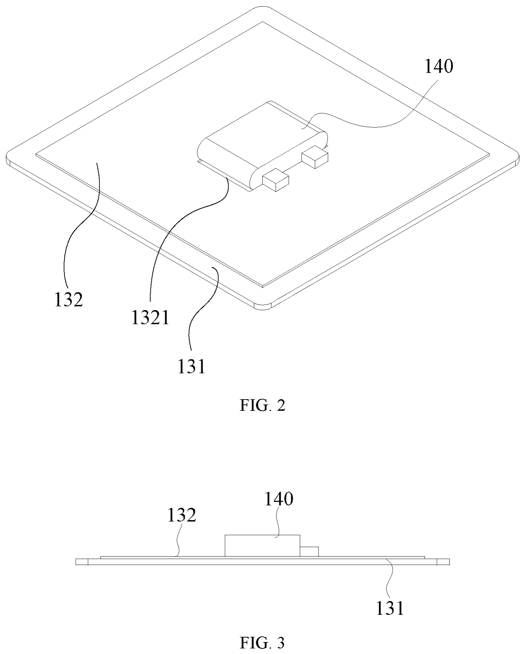

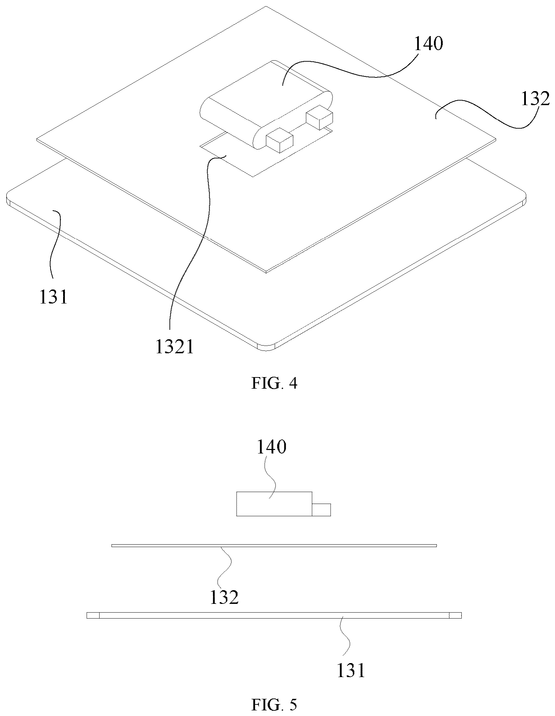

FIG. 2 is a schematic structural diagram of a supporting mechanism 130 according to some embodiments of the present application. FIG. 3 is a left view of a supporting mechanism 130 according to some embodiments of the present application. In some embodiments, with reference to FIGs. 2 and 3, the first shielding plate 132 may be closely attached to the surface of the supporting body 131. FIG. 4 is a schematic structural diagram of another supporting mechanism according to some embodiments of the present application. FIG. 5 is a left view of FIG. 4. In some other embodiments, with reference to FIGs. 4 and 5, the first shielding plate 132 may be spaced apart from the surface of the supporting body 131.

Illustratively, the material of the supporting body 131 may include, for example, carbon fibers. The supporting body 131 may be a carbon fiber plate formed by impregnating carbon fibers arranged in the same direction with resin and then curing, exhibiting advantages including low density, excellent radiation penetrability, light weight, good flexibility, high durability, corrosion resistance, and the like. The excellent radiation penetrability can reduce the impact on the imaging quality of the to-be-detected object 140.

In some embodiments of the present application, since the first shielding plate 132 is configured to block at least a portion of the radiation 170 projected onto the first shielding plate 132 from penetrating through, the requirement on the radiation penetrability of the first shielding plate 132 is relatively low. The material of the first shielding plate 132 may be lead, and the first shielding plate 132 made of lead may block to some extent the radiation 170 projected onto the first shielding plate 132 from penetrating through.

In some embodiments of the present application, as shown in FIG. 1, the radiation 170 emitted from the radiation source 110 is projected onto the first shielding plate 132, and the edge of the projection region of the radiation 170 on the plane where the first shielding plate 132 is located is positioned on the inner side of the edge of the first shielding plate 132. Two scenarios are included in this case: In the first scenario, the edge of the projection region of the radiation 170 emitted from the radiation source 110 on the plane where the first shielding plate 132 is located does not coincide with the edge of the first shielding plate 132, and is spaced apart therefrom, such that the radiation 170 emitted from the radiation source 110 is prevented from being projected onto the radiation detector 120 through the outer side of the edge of the first shielding plate 132 to form direct exposure areas, which affects the service life of the radiation detector 120. In the second scenario, the edge of the projection region of the radiation 170 emitted from the radiation source 110 on the plane where the first shielding plate 132 is located may also coincide with the edge of the first shielding plate 132. In this case, the amount of the radiation 170 projected onto the radiation detector 120 through the outer side of the edge of the first shielding plate 132 is relatively small, such that the impact on the service life of the radiation detector 120 can be reduced.

In some embodiments of the present application, the cooperation between the first shielding plate 132 and the to-be-detected object 140 may mean that the projection of the to-be-detected object 140 on the plane where the first shielding plate 132 is located and the first shielding plate 132 can together form a substantially enclosed region, such that the radiation 170 emitted from the radiation source 110 is projected onto the radiation detector 120 through at least one of the first shielding plate 132 and the to-be-detected object 140. In one embodiment, the radiation 170 emitted from the radiation source 110 may be first projected onto the first shielding plate 132, and then projected onto the to-be-detected object 140 after penetrating through the first shielding plate 132. Subsequently, the radiation is projected onto the radiation detector 120 through the to-be-detected object 140 to obtain the image of the to-be-detected object 140. In another embodiment, the radiation 170 emitted from the radiation source 110 may be first projected onto the to-be-detected object 140, and then projected onto the first shielding plate 132 after penetrating through the to-be-detected object 140. Subsequently, the radiation is projected onto the radiation detector 120 through the first shielding plate 132 to obtain the image of the to-be-detected object 140. In the above two cases, since the to-be-detected object 140 is placed within the radiation area of the radiation source 110, and the edge of the projection region of the radiation 170 emitted from the radiation source 110 on the plane where the first shielding plate 132 is located is positioned on the inner side of the edge of the first shielding plate 132, the formation of direct exposure areas caused by direct projection of the radiation onto the radiation detector 120, which affects the service life of the radiation detector 120, is reduced.

In another embodiment, a portion of the radiation 170 emitted from the radiation source 110 may be projected onto the first shielding plate 132, and then directly projected onto the radiation detector 120 after penetrating through the first shielding plate 132. The other portion of the radiation 170 emitted from the radiation source 110 may be projected onto the to-be-detected object 140, and then directly projected onto the radiation detector 120 after penetrating through the to-be-detected object 140. In this case, by configuring the first shielding plate 132 to cooperate with the to-be-detected object 140, the gap between the first shielding plate 132 and the to-be-detected object 140 can be reduced. In this way, the formation of direct exposure areas caused by direct projection of the radiation onto the radiation detector 120, which affects the service life of the radiation detector 120, is reduced.

In the embodiments of the present application, the first shielding plate 132 in the detection apparatus 100 blocks at least a portion of the radiation 170 projected onto the first shielding plate 132 from penetrating through, such that the amount of the radiation 170 emitted from the radiation source 110 that is projected onto the radiation detector 120 can be reduced. The edge of the projection region of the radiation 170 emitted from the radiation source 110 on the plane where the first shielding plate 132 is located is positioned on the inner side of the edge of the first shielding plate 132, and the first shielding plate 132 cooperates with the to-be-detected object 140, such that the radiation 170 emitted from the radiation source 110 is projected onto the radiation detector 120 through at least one of the first shielding plate 132 and the to-be-detected object 140, thereby reducing formation of direct exposure areas caused by direct projection of the radiation 170 onto the radiation detector 120, and consequently increasing the service life of the radiation detector 120.

According to some embodiments of the present application, a window 1321 is formed on the first shielding plate 132, and the window 1321 corresponds to the position of the to-be-detected object 140 on the supporting body 131.

In some embodiments of the present application, with reference to FIGs. 2 and 4, the window 1321 is formed on the first shielding plate 132, and the window 1321 corresponds to the position of the to-be-detected object 140 on the supporting body 131, such that the radiation 170 emitted from the radiation source 110 can be projected onto the radiation detector 120 through the window 1321 formed on the first shielding plate 132 and the to-be-detected object 140 to obtain the image of the to-be-detected object 140. Therefore, the regions of the first shielding plate 132 other than the window 1321 can block the radiation 170 projected onto the first shielding plate 132 from penetrating through.

In the examples shown in FIGs. 2 and 4, the window 1321 is formed in the middle of the first shielding plate 132. In some embodiments, the window 1321 may also be a notch formed along a side edge of the first shielding plate 132. In this case, during detection, the to-be-detected object 140 corresponds to the position of the window 1321, that is, the notch is filled. Therefore, in the embodiments of the present application, the edge of the first shielding plate 132 remains the edge of the first shielding plate 132 after the notch on the side edge is filled.

In the embodiments of the present application, by forming the window 1321 on the first shielding plate 132 and aligning the window 1321 with the position of the to-be-detected object 140 on the supporting body 131, the first shielding plate 132 cooperates with the to-be-detected object 140 such that the radiation 170 emitted from the radiation source 110 is projected onto the radiation detector 120 through at least one of the first shielding plate 132 and the to-be-detected object 140. Additionally, the formation of the window 1321 on the first shielding plate 132 does not affect the amount of the radiation penetrating through the to-be-detected object 140, and therefore does not impact the detection of the to-be-detected object 140.

According to some embodiments of the present application, a surface, facing the radiation source 110, of the supporting body 131 includes an accommodating groove, the accommodating groove being configured to accommodate the to-be-detected object 140.

In some embodiments of the present application, when the radiation source 110 is disposed above the supporting mechanism 130 and the radiation detector 120 is disposed below the supporting mechanism 130, the side of the supporting body 131 facing the radiation source 110 disposed above the supporting body includes an accommodating groove. During practical application, when the radiation detector 120 is disposed above the supporting mechanism 130 and the radiation source 110 is disposed below the supporting mechanism 130, the side of the supporting body 131 facing the radiation detector 120 disposed above the supporting body includes an accommodating groove.

In the embodiments of the present application, by arranging the accommodating groove on the surface, facing the radiation source 110, of the supporting body 131 to accommodate the to-be-detected object 140, the to-be-detected object 140 is securely placed on the supporting body 131. In another aspect, the blocking effect of the supporting body 131 on the radiation 170 can be reduced, and the imaging quality of the to-be-detected object 140 on the radiation detector 120 can be improved.

According to some embodiments of the present application, when the window 1321 is formed on the first shielding plate 132, the accommodating groove corresponds to the position of the window 1321, and the accommodating groove and the window 1321 have identical shape and size.

In the embodiments of the present application, by aligning the accommodating groove with the position of the window 1321, the amount of the radiation penetrating through the to-be-detected object 140 is not affected, thereby avoiding impact on the detection of the to-be-detected object 140. Meanwhile, the accommodating groove and the window 1321 are configured with identical shape and size, thereby reducing formation of direct exposure areas caused by direct projection of the radiation 170 onto the radiation detector 120, and consequently increasing the service life of the radiation detector 120.

According to some embodiments of the present application, the first shielding plate 132 is closely attached to the surface of the supporting body 131.

In the embodiments of the present application, with reference to FIGs. 2 and 3, the first shielding plate 132 is closely attached to the surface of the supporting body 131, that is, no gap exists between the first shielding plate 132 and the supporting body 131, such that the amount of the radiation projected onto the radiation detector 120 through the gap between the first shielding plate 132 and the supporting body 131 can be reduced, thereby further prolonging the service life of the radiation detector 120.

According to some embodiments of the present application, the first shielding plate 132 is disposed on the surface, facing the radiation source 110, of the supporting body 131.

In the embodiments of the present application, the first shielding plate 132 is disposed on the surface, facing the radiation source 110, of the supporting body 131, that is, the supporting body 131 supports the first shielding plate 132. The structural design is relatively simple and is easy to manufacture. When the to-be-detected object 140 is placed on the surface, facing the radiation source 110, of the supporting body 131, the amount of the radiation projected onto the radiation detector 120 through the gap between the first shielding plate 132 and the supporting body 131 can be further reduced, thereby further prolonging the service life of the radiation detector 120.

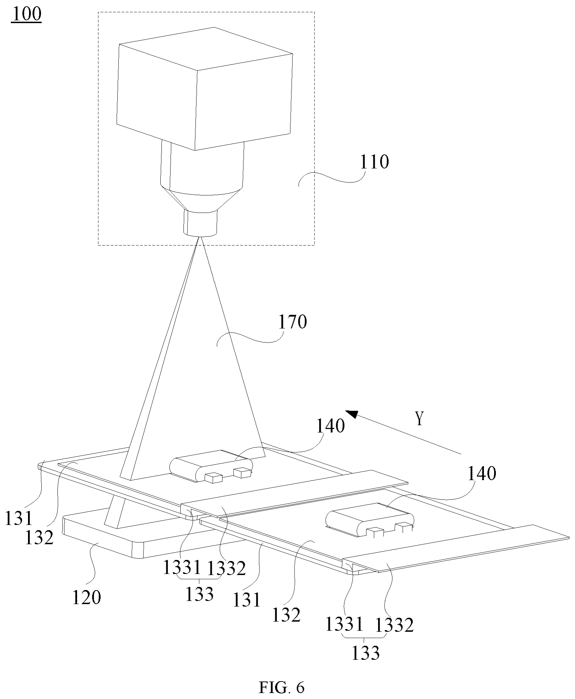

FIG. 6 is a schematic structural diagram of another detection apparatus according to some embodiments of the present application. As shown in FIG. 6, the supporting mechanism 130 includes a plurality of supporting bodies 131, the supporting mechanism 130 further includes a second shielding plate 133 disposed between two adjacent supporting bodies 131, and the orthographic projection of the second shielding plate 133 on a plane where the surface, facing the radiation source 110, of the supporting body 131 is located at least covers the gap between two adjacent supporting bodies 131.

In the embodiments of the present application, when the radiation source 110 is disposed above the supporting mechanism 130 and the radiation detector 120 is disposed below the supporting mechanism 130, the second shielding plate 133 is disposed on the side of the supporting mechanism 130 facing the radiation source 110 disposed above the supporting mechanism. When the radiation detector 120 is disposed above the supporting mechanism 130 and the radiation source 110 is disposed below the supporting mechanism 130, the second shielding plate 133 is disposed on the side of the supporting mechanism 130 facing the radiation source 110 disposed below the supporting mechanism. Meanwhile, a portion of the second shielding plate 133 may be disposed on the surface, facing the radiation source 110, of the supporting body 131.

In the embodiments of the present application, the second shielding plate 133 is disposed between two adjacent supporting bodies 131, and the orthographic projection of the second shielding plate 133 on the plane where the surface, facing the radiation source 110, of the supporting body 131 is located at least covers the gap between two adjacent supporting bodies 131, such that the radiation 170 projected onto the second shielding plate 133 can be blocked to some extent from being projected onto the radiation detector 120 through the gap between two adjacent supporting bodies 131, thereby further reducing the amount of the radiation projected onto the surface of the radiation detector 120, and prolonging the service life of the radiation detector 120.

According to some embodiments of the present application, as shown in FIG. 6, the second shielding plate 133 includes a first portion 1331 and a second portion 1332. The first portion 1331 is disposed on the surface, facing the radiation source 110, of the supporting body 131, the second portion 1332 is connected to the first portion 1331, and the orthographic projection of the second portion 1332 on a plane where the surface, facing the radiation source 110, of the supporting body 131 is located at least covers the gap between two adjacent supporting bodies 131.

In the embodiments of the present application, illustratively, the shapes of the first portion 1331 and the second portion 1332 may each be a rectangular parallelepiped. The second portion 1332 and the first portion 1331 may be fixedly connected or movably connected. The first portion 1331 is disposed on the surface, facing the radiation source 110, of the supporting body 131, and the orthographic projection of the second portion 1332 on the plane where the surface, facing the radiation source 110, of the supporting body 131 is located at least covers the gap between two adjacent supporting bodies 131, such that the second shielding plate 133 can block the radiation 170 projected onto the second shielding plate 133 from being projected onto the radiation detector 120 through the gap between the two adjacent supporting bodies 131. Meanwhile, the second shielding plate 133 has a simple structure and is easy to secure.

According to some embodiments of the present application, the distance between the surface, facing the detector, of the second portion 1332 and the surface, facing the radiation source 110, of the supporting body 131 is greater than or equal to the maximum thickness of the first shielding plate 132.

In the embodiments of the present application, by setting the distance between the surface, facing the detector, of the second portion 1332 and the surface, facing the radiation source 110, of the supporting body 131 to be greater than or equal to the maximum thickness of the first shielding plate 132, the second portion 1332 of the second shielding plate 133 may not be blocked by the first shielding plate 132, ensuring that the orthographic projection of the second shielding plate 133 on the plane where the surface, facing the radiation source 110, of the supporting body 131 is located completely covers the gap between two adjacent supporting bodies 131.

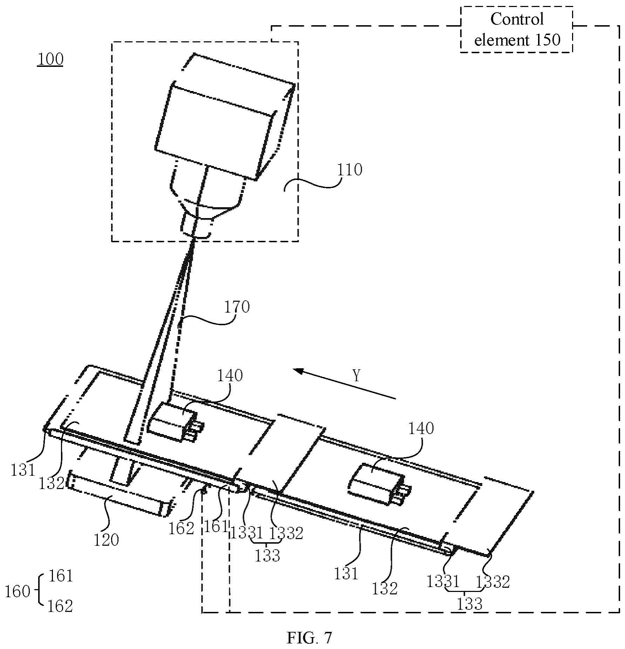

FIG. 7 is a schematic structural diagram of a detection apparatus according to some other embodiments of the present application. As shown in FIG. 7, the detection apparatus 100 further includes a control element 150 and a position detection assembly 160. The position detection assembly 160 is configured to detect position information of the to-be-detected object 140, and the control element 150 is configured to activate or deactivate the radiation source 110 based on the position information of the to-be-detected object 140.

In some embodiments of the present application, the position detection assembly 160 is configured to detect the position of the to-be-detected object 140 during the movement of the to-be-detected object 140 with the supporting mechanism 130.

In some embodiments of the present application, the control element 150 may be simultaneously connected to the radiation source 110 and the position detection assembly 160, and the control element 150 activates or deactivates the radiation source 110 based on the position information of the to-be-detected object 140 detected by the position detection assembly 160. When the position information of the to-be-detected object 140 detected by the position detection assembly 160 indicates that the to-be-detected object 140 is at a distance from the radiation detector 120 less than or equal to the preset threshold, the control element 150 activates the radiation source 110. When the position information of the to-be-detected object 140 detected by the position detection assembly 160 indicates that the to-be-detected object 140 is at a distance from the radiation detector 120 greater than the preset threshold, the control element 150 deactivates the radiation source 110.

In the embodiments of the present application, the control element 150 activates or deactivates the radiation source 110 based on the position information of the to-be-detected object 140, such that the activation and deactivation time of the radiation source 110 can be controlled, and the activation time of the radiation source 110 can be reduced, thereby decreasing the duration of radiation 170 exposure of the radiation detector 120, and further prolonging the service life of the radiation detector 120.

According to some embodiments of the present application, the detection apparatus 100 further includes a driving mechanism, where the driving mechanism is configured to drive the supporting mechanism 130 to move, the position detection assembly 160 includes a magnetic grating scale 161 and a magnetic grating scale read head 162, the magnetic grating scale 161 is disposed on the side surface of the supporting body 131 adjacent to the surface, facing the radiation source 110, of the supporting body 131 along the movement direction Y of the supporting mechanism 130, and the magnetic grating scale read head 162 obtains the position information of the to-be-detected object 140 based on magnetic pole variations of the magnetic grating scale 161.

In some embodiments of the present application, the driving mechanism is configured to drive the supporting mechanism 130 to move in the movement direction Y, thereby enabling the to-be-detected object 140 to move along the movement direction Y to the detection station.

In some embodiments of the present application, the position detection assembly 160 includes a magnetic grating scale 161 and a magnetic grating scale read head 162, and the magnetic grating scale 161 is disposed on the side surface of the supporting body 131 adjacent to the surface, facing the radiation source 110, of the supporting body 131 along the movement direction Y of the supporting mechanism 130. When the driving mechanism drives the supporting mechanism 130 to move along the movement direction Y, the magnetic grating scale read head 162 can read magnetic pole variations of the magnetic grating scale 161. The magnetic grating scale read head 162 can obtain the position information of the supporting body 131 based on the magnetic pole variations of the magnetic grating scale 161, and the position information of the to-be-detected object 140 can be obtained based on the position information of the supporting body 131.

In the embodiments of the present application, since the magnetic grating scale 161 is disposed on the side surface of the supporting body 131 adjacent to the surface, facing the radiation source 110, of the supporting body 131 along the movement direction Y of the supporting mechanism 130, and the magnetic grating scale read head 162 obtains the position information of the to-be-detected object 140 based on magnetic pole variations of the magnetic grating scale 161, the position detection assembly 160 with such structural configuration offers the advantages of structural simplicity and high detection efficiency.

The embodiments of the present application provide a battery cell detection device. The battery cell detection device includes the detection apparatus 100 in the aforementioned embodiments, and the to-be-detected object 140 is a battery cell.

In the embodiments of the present application, the battery cell may include a lithium-ion secondary battery, a lithium-ion primary battery, a lithium-sulfur battery, a sodium-lithium-ion battery, a sodium-ion battery, a magnesium-ion battery, or the like. The battery cell may be in the shape of a rectangular parallelepiped, a cube, or the like. The battery cell includes a shell, an electrode assembly, and an electrolyte, and the shell is configured to accommodate the electrode assembly and the electrolyte. The electrode assembly consists of a positive electrode plate, a negative electrode plate, and a separator. The battery cell primarily works by the movement of metal ions between the positive electrode plate and the negative electrode plate. The positive electrode plate includes a positive electrode current collector and a positive electrode active substance layer. The surface of the positive electrode current collector is coated with the positive electrode active substance layer. The positive electrode current collector not coated with the positive electrode active substance layer protrudes from the positive electrode current collector coated with the positive electrode active substance layer. The positive electrode current collector not coated with the positive electrode active substance layer serves as a positive electrode tab. Taking lithium-ion batteries as an example, the material of the positive electrode current collector may be aluminum, and the positive electrode active substance may be lithium cobaltate, lithium iron phosphate, ternary lithium, lithium manganate, or the like. The negative electrode plate includes a negative electrode current collector and a negative electrode active substance layer. The surface of the negative electrode current collector is coated with the negative electrode active substance layer. The negative electrode current collector not coated with the negative electrode active substance layer protrudes from the negative electrode current collector coated with the negative electrode active substance layer. The negative electrode current collector not coated with the negative electrode active substance layer serves as a negative electrode tab. The material of the negative electrode current collector may be copper, and the negative electrode active substance may be carbon, silicon, or the like. To ensure the passing of a large current without fusing, there are a plurality of positive electrode tabs that are stacked together, and there are a plurality of negative electrode tabs that are stacked together.

In the embodiments of the present application, by using the detection apparatus 100 in the aforementioned embodiments to detect battery cells, the detection efficiency of battery cell detection can be improved, thereby increasing the production efficiency of battery cells.

The technical solutions of the present application are further described below with a specific embodiment. As shown in FIGs. 1 to 7, the detection apparatus 100 includes a radiation source 110 and a radiation detector 120 disposed opposite to each other, and a supporting mechanism 130 located between the radiation source 110 and the radiation detector 120. The supporting mechanism 130 includes a plurality of supporting bodies 131, a first shielding plate 132, and a second shielding plate 133. The supporting body 131 is configured to carry a to-be-detected object 140, and the first shielding plate 132 is configured to block at least a portion of radiation 170 projected onto the first shielding plate 132 from penetrating through. The second shielding plate 133 is disposed between two adjacent supporting bodies 131, and the orthographic projection of the second shielding plate 133 on a plane where the surface, facing the radiation source 110, of the supporting body 131 is located at least covers the gap between two adjacent supporting bodies 131.

The edge of the projection region of the radiation 170 emitted from the radiation source 110 on a plane where the first shielding plate 132 is located is positioned on the inner side of the edge of the first shielding plate 132, and the first shielding plate 132 is configured to cooperate with the to-be-detected object 140, such that the radiation 170 emitted from the radiation source 110 is projected onto the radiation detector 120 through at least one of the first shielding plate 132 and the to-be-detected object 140.

A window 1321 is formed on the first shielding plate 132, and the surface, facing the radiation source 110, of the supporting body 131 includes an accommodating groove. The accommodating groove corresponds to the position of the window 1321, and the accommodating groove and the window 1321 have identical shape and size. The window 1321 corresponds to the position of the to-be-detected object 140 on the supporting body 131, and the accommodating groove is configured to accommodate the to-be-detected object 140.

The second shielding plate 133 includes a first portion 1331 and a second portion 1332. The first portion 1331 is disposed on the surface, facing the radiation source 110, of the supporting body 131, the second portion 1332 is connected to the first portion 1331, and the orthographic projection of the second portion 1332 on a plane where the surface, facing the radiation source 110, of the supporting body 131 is located at least covers the gap between two adjacent supporting bodies 131. The distance between the surface, facing the detector, of the second portion 1332 and the surface, facing the radiation source 110, of the supporting body 131 is greater than or equal to the maximum thickness of the first shielding plate 132.

The detection apparatus 100 further includes a driving mechanism, a control element 150, and a position detection assembly 160. The driving mechanism is configured to drive the supporting mechanism 130 to move, and the position detection assembly 160 includes a magnetic grating scale 161 and a magnetic grating scale read head 162. The magnetic grating scale 161 is disposed on the side surface of the supporting body 131 adjacent to the surface, facing the radiation source 110, of the supporting body 131 along the movement direction Y of the supporting mechanism 130, and the magnetic grating scale read head 162 obtains the position information of the to-be-detected object 140 based on magnetic pole variations of the magnetic grating scale 161. The control element 150 activates or deactivates the radiation source 110 based on the position information of the to-be-detected object 140.

In some embodiments of the present application, illustratively, the radiation detector 120 is a TDI detector. During the process of detecting the to-be-detected object 140 by the detection apparatus, the driving mechanism drives a plurality of supporting bodies 131 to move, and the to-be-detected object 140 is placed on the supporting body 131. The control element 150 the control element 150 controls, based on the position information of the to-be-detected object 140 that is obtained by the magnetic grating scale read head 162 on the basis of the magnetic pole variations of the magnetic grating scale 161, the radiation source 110 to be activated when the to-be-detected object 140 reaches the detection region. The radiation 170 emitted from the radiation source 110 is projected onto the TDI detector through at least one of the first shielding plate 132 and the to-be-detected object 140, and the to-be-detected object 140 is imaged on the TDI detector. During the detection process, the first shielding plate 132 blocks at least a portion of the radiation 170 projected onto the first shielding plate 132 from penetrating through, and the second shielding plate 133 blocks the radiation 170 from being projected into the gap between two adjacent supporting bodies 131. When the to-be-detected object 140 leaves the detection region, the control element 150 controls the radiation source 110 to be deactivated.

Finally, it should be noted that the above embodiments are only used to illustrate the technical solutions of the present application, rather than limit the same. Although the present application has been described in detail with reference to the foregoing embodiments, those of ordinary skills in the art should understand that modifications can still be made to the technical solutions recorded in the foregoing embodiments, or equivalent substitutions to some or all of the technical features can be made. However, such modifications or substitutions do not make the spirit of the corresponding technical solutions deviate from the scope of the technical solutions in the embodiments of the present application, and shall all fall within the scope of claims and specification of the present application. In particular, the technical features mentioned in the embodiments can be combined in any manner, provided that there is no structural conflict. The present application is not limited to the specific embodiments disclosed herein but includes all the technical solutions that fall within the scope of the claims.

## Claims

1. A detection apparatus (100), comprising:
a radiation source (110) and a radiation detector (120) disposed opposite to each other, and a supporting mechanism (130) located between the radiation source (110) and the radiation detector (120),
wherein the supporting mechanism (130) comprises a supporting body (131) and a first shielding plate (132), the first shielding plate (132) is configured to block at least a portion of radiation (170) projected onto the first shielding plate (132) from penetrating through,
the supporting body (131) is configured to carry a to-be-detected object (140), an edge of a projection region of the radiation (170) emitted from the radiation source (110) on a plane where the first shielding plate (132) is located is positioned on an inner side of an edge of the first shielding plate (132), and the first shielding plate (132) is configured to cooperate with the to-be-detected object (140), such that the radiation (170) emitted from the radiation source (110) is projected onto the radiation detector (120) through at least one of the first shielding plate (132) and the to-be-detected object (140).

2. The detection apparatus (100) according to claim 1, wherein a window (1321) is formed on the first shielding plate (132), and the window (1321) corresponds to a position of the to-be-detected object (140) on the supporting body (131).

3. The detection apparatus (100) according to claim 1 or 2, wherein a surface, facing the radiation source (110), of the supporting body (131) comprises an accommodating groove, the accommodating groove being configured to accommodate the to-be-detected object (140).

4. The detection apparatus (100) according to claim 3, wherein when the window (1321) is formed on the first shielding plate (132), the accommodating groove corresponds to a position of the window (1321), and the accommodating groove and the window (1321) have identical shape and size.

5. The detection apparatus (100) according to any one of claims 1 to 4, wherein the first shielding plate (132) is closely attached to a surface of the supporting body (131).

6. The detection apparatus (100) according to claim 5, wherein the first shielding plate (132) is disposed on the surface, facing the radiation source (110), of the supporting body (131).

7. The detection apparatus (100) according to any one of claims 1 to 6, wherein the supporting mechanism (130) comprises a plurality of supporting bodies (131), the supporting mechanism (130) further comprises a second shielding plate (133) disposed between two adjacent supporting bodies (131), and an orthographic projection of the second shielding plate (133) on a plane where the surface, facing the radiation source (110), of the supporting body (131) is located at least covers a gap between two adjacent supporting bodies (131).

8. The detection apparatus (100) according to claim 7, wherein the second shielding plate (133) comprises a first portion (1331) and a second portion (1332), the first portion (1331) is disposed on the surface, facing the radiation source (110), of the supporting body (131), the second portion (1332) is connected to the first portion (1331), and an orthographic projection of the second portion (1332) on a plane where the surface, facing the radiation source (110), of the supporting body (131) is located at least covers a gap between two adjacent supporting bodies (131).

9. The detection apparatus (100) according to claim 8, wherein a distance between a surface, facing the detector, of the second portion (1332) and the surface, facing the radiation source (110), of the supporting body (131) is greater than or equal to a maximum thickness of the first shielding plate (132).

10. The detection apparatus (100) according to any one of claims 1 to 9, wherein the detection apparatus (100) further comprises a control element (150) and a position detection assembly (160), the position detection assembly (160) being configured to detect position information of the to-be-detected object (140), and the control element (150) being configured to activate or deactivate the radiation source (110) based on the position information of the to-be-detected object (140).

11. The detection apparatus (100) according to claim 10, wherein the detection apparatus (100) further comprises a driving mechanism, the driving mechanism is configured to drive the supporting mechanism (130) to move, the position detection assembly (160) comprises a magnetic grating scale (161) and a magnetic grating scale read head (162), the magnetic grating scale (161) is disposed on a side surface of the supporting body (131) adjacent to the surface, facing the radiation source (110), of the supporting body (131) along a movement direction of the supporting mechanism (130), and the magnetic grating scale read head (162) obtains the position information of the to-be-detected object (140) based on magnetic pole variations of the magnetic grating scale (161).

12. A battery cell detection device, comprising the detection apparatus (100) according to any one of claims 1 to 11, wherein the to-be-detected object (140) is a battery cell.
